# EUROPEAN PATENT APPLICATION

(11) **EP 2 285 184 A1**
(43) Date of publication of application: **16.02.2011**
(21) Application number: 09746498.6
(22) Date of filing: 28.04.2009
(51) Int. Cl.: H05B 33/10, H01L 51/50, H05B 33/04

(54) **ORGANIC EL PANEL MANUFACTURING METHOD AND MANUFACTURING DEVICE**

(30) Priority: 12.05.2008 JP 2008124331
(71) Applicant: Yamagata Promotional Organization for Industrial Technology, Yamagata-shi Yamagata 990-2473 (JP)
(72) Inventor: SUZUKI Joji, Yamagata-shi Yamagata 990-2473 (JP); KAJIKAWA Fujio, Yamagata-shi Yamagata 990-2473 (JP); KAWAI Takashi, Yamagata-shi Yamagata 990-2473 (JP)
(74) Representative: HOFFMANN EITLE
(86) International application number: PCT/JP2009/058339
(87) International publication number: WO 2009/139291

(57) **Abstract**

There are executed a coating or attaching process for coating or attaching a grease-like or gel-like material onto a surface of a sealing substrate on a sealed space side and a drying process for drying the grease-like or gel-like material coated or attached onto the sealing substrate. Then, there is executed a laminating process of sealing the peripheral edge portion between the sealing substrate and the element formation substrate by a sealing agent such as an adhesive in such a state that the surface of the sealing substrate onto which the grease-like or gel-like material is coated or attached and the surface of the element formation substrate on which an organic EL element is formed are opposed to each other.

## Description

### [Field of the Invention]

This invention relates to a method and device for manufacturing an organic EL light-emitting panel in which grease or a gel agent is filled in between a sealing substrate and an element formation substrate with an organic EL element.

### [Description of the Related Art]

An organic EL element is driven by a DC power supply with a low voltage to thereby provide a high light-emitting efficiency, and can be reduced in weight and thickness, whereby the organic EL element is used in a flat panel display (FPD) in some portable apparatuses. In addition, there is provided one in which the organic EL element as a surface light-emitting source is used as, for example, a backlight for a liquid crystal display element.

Meanwhile, the organic EL element can provide various light emission colors depending on the selection of a material used for a light-emitting layer. Accordingly, one or a combination of two or more kinds of the light emission colors can provide an arbitrary light emission color. Therefore, the organic EL element is constituted as a surface light-emitting source (light-emitting panel) having a relatively large area, whereby the organic EL element can be used for, for example, a light-emitting poster for advertisement and an illumination light source, and in addition, used as a high efficiency light source for illuminating a room, a car interior, or the like.

In the organic EL element, a direct current voltage is applied between opposed electrodes, whereby an electron injected from a negative electrode and a hole injected from a positive electrode are recombined with each other in the light-emitting layer, and the organic EL element emits light when the energy level of the recombination is changed from excited state to ground state. Therefore, the light emitted from the light-emitting layer is required to be taken out to the outside, and thus, a transparent electrode is used for at least one electrode. As the transparent electrode, indium tin oxide (ITO) or the like is normally used.

The ITO constituting the transparent electrode has electrical resistivity of about 1×10⁻⁴ Ωcm, which is one or two figures higher than that of normal metal materials. Thus, direct current for driving the organic EL element to emit light flows into the transparent electrode, whereby the transparent electrode generates heat by the electric resistance.

The organic EL element has such a characteristic that it emits light when a voltage equal to or larger than a light emission threshold voltage inherent in the element is applied thereto in a forward direction. As a value of the current applied thereto increases, the light emission brightness of the organic EL element increases.

Meanwhile, as described above, the resistance value of the transparent electrode such as ITO constituting the organic EL element is high, and the current more easily flows near a power-feeding part of an organic EL light-emitting panel than a portion distant from the power-feeing part. Thus, even when the entire light-emitting panel is driven by constant current, the electric current value near the power-feeding part is higher than that in the portion distant from the power-feeding part, whereby the portion near the power-feeding part is more brightly illuminated, leading to the occurrence of unevenness of the light emission brightness. In addition, the current not contributive to the light emission of the organic EL light-emitting element is converted to heat, and therefore, in a bright portion, that is, a portion to which a large amount of current is applied, the absolute amount of the current not contributive to the light emission of the organic EL light-emitting element is large, and the amount of heat generation is larger than that of a dark portion.

The temperature of the organic EL element is increased by the heat generation to facilitate the flow of current, and the current is applied, in a runaway manner, to a region with relatively high current and voltage for brighter light emitting purposes, leading to the possibility of destruction of the organic EL element.

As described above, there occurs a problem that the unevenness of the light emission brightness of the EL element occurs due to the influence of the heat generation of the transparent electrode constituting the organic EL element and the influence of the heat generation caused by the characteristics of the organic EL element. When a surface light-emitting source having a relatively large area is formed of the organic EL element, there occurs such a brightness gradient (brightness unevenness) that the central portion of the surface light-emitting source is generally dark, and the portion near the power-feeding part provided around the central portion is bright.

The organic EL light-emitting panel of this invention attempts to prevent the occurrence of the brightness unevenness accompanying the heat generation of the organic EL element. Although the problem to be solved is different from this invention, Patent Documents 1 to 3 disclose an organic EL light-emitting device which attempt to prevent deterioration of a thin-film material in an organic layer by sealing the organic EL element in a sealed space.
[Patent Document 1] Japanese Patent Application Laid-Open No. 2000-357587
[Patent Document 2] Japanese Patent Application Laid-Open No. 2001-217071
[Patent Document 3] Japanese Patent Application Laid-Open No. 2003-173868

In the organic EL light-emitting device disclosed in the Patent Document 1, the four sides of the opening of the sealing member with a recessed cross-sectional surface are attached to the element formation substrate, on which the organic EL element is formed, through the adhesive. The drying agent is disposed on the inner surface of the sealing member, and an inert gas is filled and sealed in the space formed between the element formation substrate and the sealing member.

In the organic EL light-emitting device disclosed in the Patent Document 2, the sealing member with a recessed cross-sectional surface is attached onto the element formation substrate on which the organic EL element is formed, and the drying agent consisting of inert liquid is injected into the space between the element formation substrate and the sealing member. In the description of the document, the drying agent consisting of inert liquid protects the organic EL element and prevents the deterioration of a thin-film material in an organic layer.

In the organic EL light-emitting device disclosed in the Patent Document 3, the element formation substrate on which the organic EL element is formed is covered by a cap glass. A sealing liquid such as silicon oil is filled and sealed in the space in which the organic EL element covered by the cap glass is disposed, and the peripheral edge between the element formation substrate and the cap glass is sealed by a sealing agent. In the description of this organic EL light-emitting device disclosed in Japanese Patent Application Laid-Open No. 2003-173868, the organic EL element can be moistureproofed by the sealing liquid.

In addition to the organic EL light-emitting devices disclosed in Patent Documents 1 to 3, there are many patent documents disclosing such a constitution that the organic EL element formed on the element formation substrate is sealed; however, most of these documents focus on the moistureproof of the organic EL element and the prevention of the generation of a so-called dark spot (a minute non-light-emitting portion in a light-emitting area) in the organic EL element.

### [Disclosure of the Invention]

### [Problems to be Solved by the Invention]

In order to realize a satisfactory moistureproof measure for the organic EL element, as disclosed in the above patent documents, and, in addition, in order to prevent the occurrence of unevenness of the light emission brightness accompanying heat generation, the inventors of the present application propose an organic EL light-emitting panel, in which a grease or a gel agent is filled in a sealed space including the organic EL element, and have performed experiments. According to the organic EL light-emitting panel, it has been verified that heat generated from the organic EL light-emitting panel is effectively dissipated as described later, whereby the occurrence of the brightness unevenness can be prevented.

Thus, this invention proposes a method and a device for manufacturing an organic EL light-emitting panel in which a grease or a gel agent is filled in the sealed space including the organic EL element, and an object of this invention is to provide a method and a device for manufacturing an organic EL light-emitting panel which can realize the application of a satisfactory moistureproof measure to the organic EL element without stressing or damaging the organic EL element in the manufacturing process and can effectively prevent the occurrence of the brightness unevenness.

Another object of this invention is to provide a method and a device for manufacturing an organic EL light-emitting panel, which can be manufactured without providing a coating process of coating the grease or the gel agent to the sealing substrate side by using, for example, printing means and can be manufactured by using atmospheric pressure for the tight holding of the substrates even if an auxiliary plate formed of expensive UV transmitting glass such as thick quartz glass is not used, whereby a low-cost manufacturing method and device suitable for increasing in size of a substrate glass are provided.

### [Means for Solving the Problems]

In order to achieve the above object, this invention provides a method for manufacturing an organic EL light-emitting panel. In this method, an organic EL element formed on an element formation substrate is sealed so as to provide a sealed space between the element formation substrate and a sealing substrate facing the element formation substrate, and a grease-like or gel-like material is filled in the sealed space between the element formation substrate and the sealing substrate. This method is characterized by including a coating process of coating or attaching the grease-like or gel-like material onto a surface of the sealing substrate and a laminating process of sealing the peripheral edge portion between the sealing substrate and the element formation substrate by a sealing agent in such a state that the surface of the sealing substrate onto which the grease-like or gel-like material is coated or attached and the surface of the element formation substrate on which the organic EL element is formed are opposed to each other.

In the above case, after the coating or attaching process, a drying process is preferably executed. In the drying process, the grease-like or gel-like material coated or attached onto the sealing substrate is dried. The laminating process is executed after the drying process. Further, the drying process is preferably executed in a range of temperature of 100°C to 250°C.

Further, a process for cleaning the sealing substrate and a process of applying or attaching a sealing agent are executed after the coating or attaching process. In the cleaning process, a sealing portion of the sealing substrate to which the sealing agent is applied is dry cleaned. In the sealing agent applying or attaching process, the sealing agent is applied or attached to the sealing portion of the sealing substrate after the cleaning process. The laminatingprocess maybe executed using the sealing agent applied or attached in the sealing agent applying or attaching process. In this case, the normal-pressure plasma cleaning is preferably used in the dry cleaning.

Further, a decompression process is preferably executed before the laminating process. In the decompression process, a gas in a chamber in which the sealing substrate and the element formation substrate are accommodated is discharged. Under decompression, there is executed the laminating process for adhering the surface of the sealing substrate, onto which a grease or a gel agent is coated or attached, to the surface of the element formation substrate on which the organic EL element is formed.

In addition, in the laminating process, the lamination pressure applied to the sealing substrate and the element formation substrate is set to 1 Pa to 50000 Pa. It is preferable that a sealing agent hardening process for hardening the sealing agent is executed while maintaining the pressure.

In one preferred embodiment, a UV curable resin is used as the sealing agent, and there is executed a process for hardening the UV curable resin by using UV light while maintaining the lamination pressure in the laminating process.

In another preferred embodiment, a frit agent such as a glass paste is used as the sealing agent, and there is executed a process for heating and fusion bonding the glass paste by laser irradiation while maintaining the laminationpressure in the laminating process.

The grease-like or gel-like material preferably contains synthetic zeolite as a moisture absorbent, and when a sealing substrate formed into a plate shape is used, it is preferable that the synthetic zeolite is contained in the grease-like or gel-like material in a weight ratio of 10 to 80%, and the thickness of a grease layer or a gel layer containing the moisture absorbent is set to a range of 10 to 100 µm.

When a sealing substrate with a recessed cross-sectional surface, in which a recess is provided in the central portion so that the peripheral edge portion is in contact with the element formation substrate side, is used, the synthetic zeolite is contained in the grease-like or gel-like material in a weight ratio of 10 to 80%, the amount of the grease-like orgel-like material containing a moisture absorbent is set so that the grease-like or gel-like material is filled in the recess of the sealing substrate to adhere to the organic EL element, and the thickness of a grease layer or a gel layer containing the moisture absorbent is set to a range of 10 to 500 µm.

Inonepreferredmethod, in the laminating process for adhering the element formation substrate and the sealing substrate, at least one of the element formation substrate and the sealing substrate adheres to a film-like sheet disposed in a lamination stage, whereby the organic EL light-emitting panel is fixed and positioned.

In the above case, a process for hardening sealing agent in a peripheral portion of the organic EL panel is executed in such a state that a side where the film-like sheet for fixing and positioning the organic EL panel and the organic EL panel are in contact with each other is in a decompression state of 1 Pa to 50000 Pa, and a side where the film-like sheet and the organic EL panel are not in contact with each other is in an atmospheric pressure state.

Meanwhile, in order to achieve the above obj ect, this invention provides a device for manufacturing an organic EL light-emitting panel. In this device, an organic EL element formed on an element formation substrate is sealed so as to provide a sealed space between the element formation substrate and a sealing substrate facing the element formation substrate, and a grease-like or gel-like material is filled in the sealed space between the element formation substrate and the sealing substrate. This device is characterized by including a coating or attaching stage in which the grease-like or gel-like material is coated or attached onto a surface of the sealing substrate and a lamination stage in which the peripheral edge portion between the sealing substrate and the element formation substrate is sealed by a sealing agent in such a state that the surface of the sealing substrate onto which the grease-like or gel-like material is coated or attached and the surface of the element formation substrate on which the organic EL element is formed are opposed to each other.

In the above case, the manufacturing device further includes a heating and drying stage in which the grease-like or gel-like material coated or attached on the surface of the sealing substrate in the coating or attaching stage is heated and dried, and it is preferable toprovide feedingmeans for feeding the sealing substrate to the lamination stage after the heating and drying processing in the heating and drying stage.

In addition, the manufacturing device further includes a cleaning and sealing-agent-application/attachment stage in which a sealing portion of the sealing substrate processed in the heating and drying stage is dry cleaned, and a sealing agent is applied or attached to the dry cleaned position. It is preferable that the sealing substrate processed in the cleaning and sealing-agent-application/attachment stage is fed to the laminating state by the feeding means. In this case, dry cleaning means for dry cleaning the sealing portion of the sealing substrate preferably uses normal-pressure plasma cleaning means.

The lamination stage includes laminating means, which adheres the surface of the sealing substrate, onto which the grease or the gel agent is coated or attached, to the side of the organic EL element on the element formation substrate at a predetermined lamination pressure. In this case, it is preferable that in the lamination stage, the surface of the sealing substrate, onto which the grease or the gel agent is coated or attached, is adhered to the organic EL element side on the element formation substrate at a predetermined lamination pressure under decompression.

In one preferred embodiment, a chamber constituting the lamination stage has a pressure regulating function of decompressing the inside of the chamber and returning the decompression state to atmospheric pressure. Even when a lamination pressure in the lamination stage is released by a pressure difference between a sealed decompression space between the sealing substrate and the element formation substrate when the inside of the chamber is in the decompression state and the space when the decompression state in the chamber is returned to the atmospheric pressure, the adhesion and the positional relationship between the sealing substrate and the element formation substrate are maintained.

In addition, the manufacturing device further includes a sealing agent hardening stage in which the sealing agent is hardened in such a state that the adhesion and the positional relationship between the element formation substrate and the sealing substrate are maintained.

In another preferred embodiment of the manufacturing device according to this invention, in the laminating means for adhering the element formation substrate and the sealing substrate in the lamination stage, at least one of the element formation substrate and the sealing substrate is adhered to the film-like sheet disposed in the lamination stage, whereby the organic EL light-emitting panel is fixed and positioned.

In the above case, it is preferable that the manufacturing device includes a sealing agent hardening stage in which a sealing agent in a peripheral portion of the organic EL panel is hardened in such a state that a side of the film-like sheet on which the organic EL panel is fixed and positioned is in a decompression state of 1 Pa to 5000 Pa and a side where the film-like sheet and the organic ELpanel are not in contact with each other is in an atmospheric pressure state.

The sealing agent hardening stage includes UV irradiation means which hardens UV curable resin as a sealing agent or laser irradiation means which heats and fusion-bonds an inorganic frit agent such as glass paste as a sealing agent.

According to the method and device for manufacturing an organic EL light-emitting panel, there is executed the coating or attaching process for coating or attaching the grease-like or gel-like material on one side of the sealing substrate. Thus, the grease-like or gel-like material can realize that processing, such as the heating and drying and the dry cleaning of the sealing portion, executed only by the sealing substrate side in such a state that the grease-like or gel-like material is coated or attached on the sealing substrate side. Namely, the element formation substrate on which the organic EL element is film-formed is laminated after the processing such as the heating and drying and the dry cleaning, whereby it is possible to prevent the organic EL element from being stressed due to the processing.

Further, in the lamination process, the peripheral edge portion between the sealing substrate and the element formation substrate is sealed by the sealing agent in such a state that the surface of the sealing substrate onto which the grease-like or gel-like material is coated or attached and the surface of the element formation substrate on which the organic EL element is formed are opposed to each other, whereby the sealing portion formed of the sealing agent is formed in the peripheral edge portion between the element formation substrate and the sealing substrate, and the grease layer or the gel layer is accommodated in between the element formation substrate on which the organic EL element surrounded by the sealing portion is formed and the sealing substrate in a state of tightlyadhering to the element formation substrate and the sealing substrate.

According to an embodiment in which the grease layer or the gel layer is sealed in the accommodation space of the organic E1 element, the thermal conductivity can be increased compared with the constitution disclosed in the Japanese Patent Application Laid-Open Nos. 2000-357587, 2001-217071, and 2003-173868, in which a gas or a liquid is filled and sealed in between the element formation substrate, on which the organic EL element is formed, and the sealing substrate. Accordingly, the heat dissipation of the organic EL light-emitting panel can be accelerated through the grease layer or the gel layer, and, at the same time, the entire temperature can be uniformly maintained.

According to the above constitution, even in the organic EL light-emitting panel having a relatively large light-emitting area, the operational temperature can be rendered uniform, whereby the brightness unevenness in the organic EL light-emitting panel generated due to the influence of the characteristics of the organic EL element and the influence of the heat generation of the organic EL element can be effectively prevented.

The grease layer or the gel layer serves for moistureproof of the organic EL element. The moisture absorbent is dispersed in the grease layer or the gel layer, whereby the light-emitting panel, which can realize a further increase in the moistureproof effect for the organic EL element with the aid of the moisture absorbent, can be provided.

Further, the grease layer or the gel layer contains a heat-transfer agent, whereby the heat dissipation effect is increased. For example, the grease layer or the gel layer contains a material having functions as a moisture absorbent and a heat-transfer agent, such as synthetic zeolite and silica gel, whereby the light-emitting panel which can realize further heat dissipation and moistureproof effect can be provided.

### [Brief Description of the Drawings]

[FIG. 1] Fig. 1 is across -sectional view schematically showing a basic structure of an organic EL light-emitting panel manufactured by a manufacturing method and device according to this invention;
[FIG. 2] Fig. 2 is a plan view explaining an example of a laminated structure of the organic EL element in the light-emitting panel shown in FIG. 1;
[FIG. 3] Fig. 3 is a schematic view showing the entire structure of the manufacturing device according to this invention;
[FIG. 4A] Fig. 4A is a schematic view explaining a process at an initial stage in a first example where the organic EL light-emitting panel shown in FIG. 1 is manufactured ;
[FIG. 4B] FIG. 4B is a schematic view explaining a process following FIG. 4A;
[FIG. 4C]FIG. 4C is a schematic view explaining a process following FIG. 4B;
[FIG. 5] FIG. 5 is a flow chart explaining a first manufacturing method according to this invention;
[FIG. 6] FIG. 6 is a top view of a sealing substrate in which a position subjected to dry cleaning is schematically shown;
[FIG. 7A]FIG. 7A is a schematic view explaining a process at an initial stage in a second example where the organic EL light-emitting panel shown in FIG. 1 is manufactured;
[FIG. 7B] FIG. 7B is a schematic view explaining a process following FIG. 7A;
[FIG. 7C]FIG. 7C is a schematic view explaining a process following FIG. 7B;
[FIG. 8] FIG. 8 is a flow chart explaining a second manufacturing method according to this invention;
[FIG. 9] FIG. 9 is a schematic view showing an embodiment of a prototype produced for measurement;
[FIG. 10] FIG. 10 is an explanatory view showing an example of a laminated structure of the prototype of the organic EL element;
[FIG. 11] FIG. 11 is a table showing a result of temperature measurement;
[FIG. 12]FIG. 12 is a diagram showing a measurement result of a surface temperature when applying current to the light-emitting panel; and
[FIG. 13] FIG. 13 is a diagram showing an enlarged scale of a part of FIG. 12.

### [Reference Letters and Numerals]

1 element formation substrate
2 organic EL element
2A transparent electrode
2B organic light-emitting layer
2C opposed electrode
2D protective film
3 sealing substrate
4 sealing portion (adhesive)
5 grease layer, gel layer(grease agent, gel agent)
7 sealing portion
11 heater
12, 13 electrode
14 application nozzle
15 laminating device
16, 18 auxiliary plate
17 UV transmitting glass
17A UV cut mask
19 UV projection lamp
21 film-like sheet
E1 DC power supply
L light-emitting part

### [Description of the Preferred Embodiments]

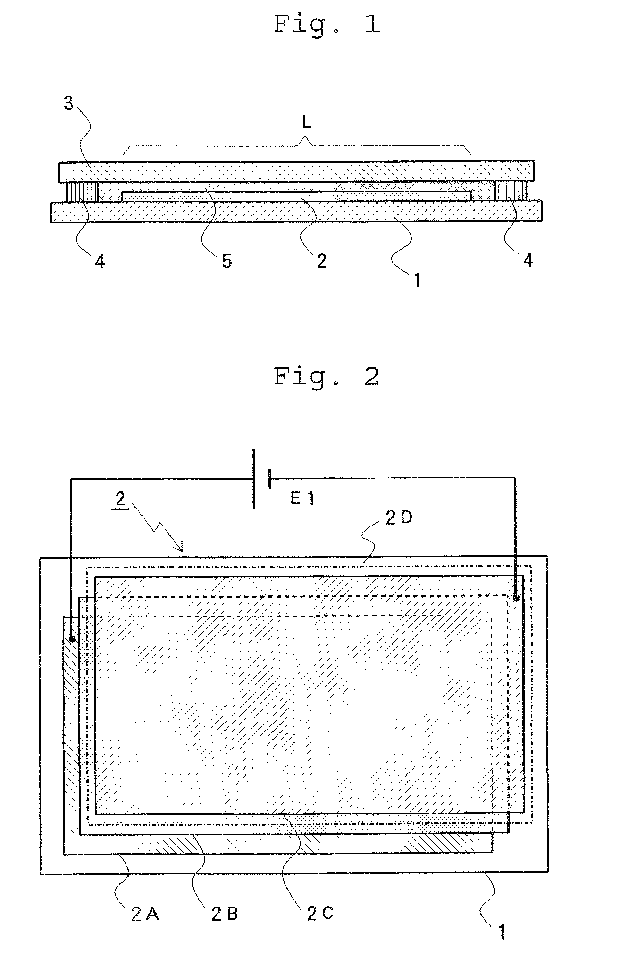

Hereinafter, a method and device for manufacturing an organic EL light-emitting panel according to this inventionwill be described. First, a basic embodiment of the organic EL light-emitting panel to be obtained by the manufacturing method and the manufacturing device will be described based on FIGS. 1 and 2.

FIG. 1 is a schematic view (cross-sectional view) of an example of a basic structure of the organic EL light-emitting panel of this invention. An element formation substrate 1 is formed of a transparent material such as glass and formed into a rectangular shape. The element formation substrate 1 has on its one side (the upper surface shown in FIG. 1) an organic EL element 2 stacked thereon.

Further, a plate-shaped sealing substrate 3, formed into a rectangular shape like the element formation substrate 1, is disposed so as to face the surface of the element formation substrate 1, on which the organic EL element 2 is stacked. The element formation substrate 1 and the sealing substrate 3 are sealed at the peripheral edge portion of the four sides through a sealing portion 4 formed of a sealing agent (an adhesive). A space is provided between the element formation substrate 1 with the organic EL element 2 surrounded by the sealing portion 4 and the plate-shaped sealing substrate 3, and a grease layer 5 or a gel layer 5, which is in a semi-solid state at a normal temperature, is accommodated in the space so as to tightly adhere to the element formation substrate 1 and the plate-shaped sealing substrate 3.

Namely, the grease layer 5 or the gel layer 5 in the organic EL light-emitting panel of FIG. 1 is accommodated so as to substantially fill in the space formed between the element formation substrate 1 and the sealing substrate 3, whereby the grease layer 5 or the gel layer 5 is formed to have a larger size than the outer periphery of a light-emitting part L (a portion of an organic light-emitting layer 2B sandwiched between a transparent electrode 2A and an opposed electrode 2C, which are described later) of the organic EL element 2 facing the grease layer 5 or the gel layer 5.

Although the sealing substrate 3 shown in FIG. 1 is formed into a plate shape, a sealing substrate with a recessed cross-sectional surface, in which a recess is provided in the central portion by, for example, etching means so that the peripheral edge portion is in contact with the element formation substrate side, can be suitably used.

FIG. 2 shows an example of the basic structure of the organic EL element 2 formed on the element formation substrate 1. In FIG. 2, each layer constituting the organic EL element 2 is separated in a layer direction. Namely, this type of the organic EL element 2 has on one side of the element formation substrate 1 the transparent electrode 2A formed in a predetermined pattern. The transparent electrode 2A is a first electrode and formed of, for example, ITO.

An organic light-emitting layer 2B is formed so as to be superimposed on the transparent electrode 2A. The organic light-emitting layer 2B is constituted of, for example, a hole transportation layer, a light-emitting layer, and an electron transportation layer; however, in FIG. 2, the organic light-emitting layer 2B is shown as one layer. The opposed electrode 2C, which is a second electrode and formed of for example, aluminum is formed so as to be superimposed on the organic light-emitting layer 2B.

The organic EL element 2 constituted of the transparent electrode 2A, the organic light-emitting layer 2B, and the opposed electrode 2C, as needed, further includes a protective film 2D, which is constituted of an organic or inorganic layer and is film- formed so as to cover the entire light-emitting part L sandwiched between at least the transparent electrode 2A and the opposed electrode 2C of the organic El element 2. According to this constitution, the organic EL element 2 is constituted so as to be in contact with the grease layer or the gel layer through the protective film 2D.

A DC power supply E1 is connected between the transparent electrode 2A and the opposed electrode 2C, whereby the portion (the light-emitting part L) of the organic light-emitting layer 2B sandwiched between the transparent electrode 2A and the opposed electrode 2C emits light, and the light transmits through the transparent electrode 2A and the element formation substrate 1 to be derived outside.

As in the organic EL light-emitting panel disclosed in the Japanese Patent Application Laid-Open Nos. 2000-357587, 2001-217071, and 2003-173868, when an inert gas such as nitrogen or an inert liquid such as fluorine oil is sealed in the organic EL light-emitting panel, as described above, due to the above described reason, there occurs such a brightness gradient (brightness unevenness) that the central portion of the surface light-emitting source is dark, and the portion near the power-feeding part provided around the central portion is bright.

Thus, in the light-emitting panel shown in FIGS. 1 and 2, the grease layer 5 or the gel layer 5 is accommodated in between the element formation substrate 1 with the organic EL element 2 film-formed thereon and the sealing substrate 3 opposed to element formation substrate 1 in a state of tightly adhering to the element formation substrate 1 and the sealing substrate 3. The grease layer 5 or the gel layer 5 has good heat conduction properties to thereby effectively prevent the occurrence of the brightness unevenness even in the organic EL light-emitting panel having a relatively large area.

It is preferable that the grease layer 5 or the gel layer 5 contains an oligomer or a polymer containing organosiloxane (-R₁R₂SiO-: R₁ and R₂ represent a saturated or unsaturated alkyl group, a substituted or unsubstitued phenyl group, or a saturated or unsaturated fluoloalkyl group.) or fluorinated polyether (-CF₂CFYO-: Y represents F or CF₃.) in the skeleton, and further contains as an additive a moisture absorbent or a heat-transfer agent, or the moisture absorbent and the heat-transfer agent.

As the oligomer or polymer having organosiloxane bond (-R₂SiO-) as a skeleton, an oligomer or a polymer having a dimethylsiloxane bond (-(CH₃)₂SiO-) as a skeleton can be preferably used. Specifically, SE1880 from Dove Corning Toray Co., Ltd. or KE1057 from Shin-Etsu Chemical Co., Ltd. can be used.

As the organosiloxane, an oligomer or a polymer containing -(R₁R₁SiO)₁-(R₁R₂SiO)ₘ-(R₁R₃SiO)ₙ-(R₁ represents a methyl group, R₂ represents a vinyl group or a phenyl group, R₃ represents a fluoloalkyl group of -CH₂CH₂CF₃, and 1, m, and n represent integer numbers, and one or two of three figures may be 0.) in the skeleton can be preferably used.

As the fluorinated polyether, an oligomer or a polymer, which contains - CF₂CFYO- (Y represents F or CF₃) in the skeleton and has a functional group containing Si at the terminal can be used. For example, SIFEL8470, 8370 from Shin-Etsu Chemical Co., Ltd., can be used.

It is preferable that the moisture absorbent is contained in the grease layer 5 or the gel layer 5 in a state of being dispersed therein. The moisture absorbent catching water by chemisorption or physisorption can be used. A preferred example of the moisture absorbent performing chemisorption includes a fine powder such as calcium oxide, barium oxide, and strontium oxide. A preferred example of the moisture absorbent performing physisorption includes synthetic zeolite and silica gel. In addition, a structure of the moisture absorbent may be prepared by applying an organometallic complex liquid moisture absorbent and drying or hardening. For example, Ole Dry from Futaba Corporation can be used.

The heat-transfer agent contained in the grease layer 5 or the gel layer 5 is a metal oxide selected from, for example, silicon oxide, aluminum oxide, calcium oxide, barium oxide, and strontium oxide, a fine powder of nitride selected from silicon nitride and aluminum nitride, or a mixture of one or a plurality of kinds of synthetic zeolite and silica gel. The heat-transfer agent is preferably dispersed in the grease layer 5 or the gel layer 5 when used.

When the plate-shaped sealing substrate 3 is used as shown in FIG. 1, and for example when the grease layer 5 or the gel layer 5 contains synthetic zeolite as the additive, the synthetic zeolite is contained in the grease layer 5 or the gel layer 5 in a weight ratio of 10 to 80%. The thickness of the grease layer 5 or the gel layer 5 containing the additive is preferably set in a range of 10 to 100 µm.

When the additive is contained in a weight ratio of less than 10%, the moisture absorption effect and the heat-transfer effect are reduced. Meanwhile, when the weight ratio is more than 80%, a shape retention property is too high, whereby there arises a problem that desired coating or attachment cannot be obtained.

Although the thickness of the grease layer or the gel layer containing the additive is determined to be 10 to 100 µm, this is because if the thickness is less than 10 µm, damage is applied to the element when applying pressure to the sealing substrate and the element formation substrate, and it has been found that a failure, such as a short between electrodes and a dark area, is increased at a rate of 30% or more.

As found in the experiments by the inventor of the present invention, when the thickness is more than 100 µm, the thickness of the peripheral adhered portion becomes 100 µm or more, the amount of water diffusing from the adhered portion into the panel is increased, whereby there arises a problem that the rate of enlargement of the dark area is increased in the moisture resistance test at 60°C/90%.

Meanwhile, as described above, when the sealing substrate 3 having a recessed cross-sectional surface with a recess in its central portion is used, it is suitable that the synthetic zeolite is contained in the grease layer 5 or the gel layer 5 in a weight ratio of 10 to 80%, as in the case using the plate-shaped sealing substrate. It is preferable that the thickness of the grease layer 5 or the gel layer 5 containing the additive is set to correspond to the depth of the recess of the sealing substrate 3. Namely, it is preferable that the amount of the grease layer 5 or the gel layer 5 is set to be satisfactorily filled in the recess of the sealing substrate 3 to adhere to the organic EL element.

As described above, the moisture absorbent is dispersed in the grease layer 5 or the gel layer 5, whereby a phenomenon of deterioration of the element, such as the occurrence and enlargement of the dark spot in the organic EL element, canbe effectivelyreduced. Further, the heat-transfer agent is contained in the grease layer 5 or the gel layer 5, whereby the unique heat-transfer properties of the grease layer 5 or the gel layer 5 and the other properties can be promoted, and contributing to more effective prevention of the occurrence of the brightness unevenness in the organic EL light-emitting panel.

The protective film 2D is in contact with the grease layer 5 or the gel layer 5 and formed on the uppermost portion of the organic EL element 2. The protective film 2D is preferably formed of silicon oxide and silicon nitride, such as SiO, SiO₂, SiON, and Si₃N₄, or an organic substance used as the hole transportation layer, the electron transportation layer, and the light-emitting layer of the organic EL element, and a barrier layer and a charge generating layer of a carrier, such as α-NPD (Bis[N-(1-naphthyl)-N-pheny]benzidine) or Alq[Tris(8-hydroxyquinolinato)aluminum(III)]. The protective film 2D is constituted of a laminated film of one or a plurality of kinds of the above components.

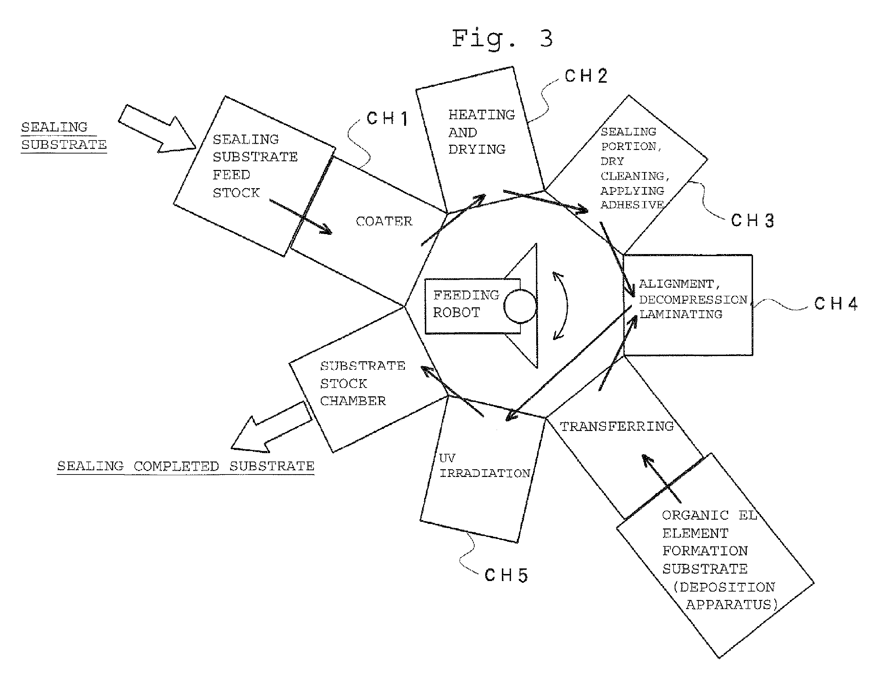

Next, the method and device for manufacturing the organic EL light-emitting panel including the grease layer 5 or the gel layer 5, according to the invention, will be described based on the drawings. FIG. 3 schematically shows an example of the manufacturing device. Stages of a chamber in which each processing is performed are formed so as to surround feeding means (a feeding robot) disposed on the center. An arrow in FIG. 3 shows the flow of the processing.

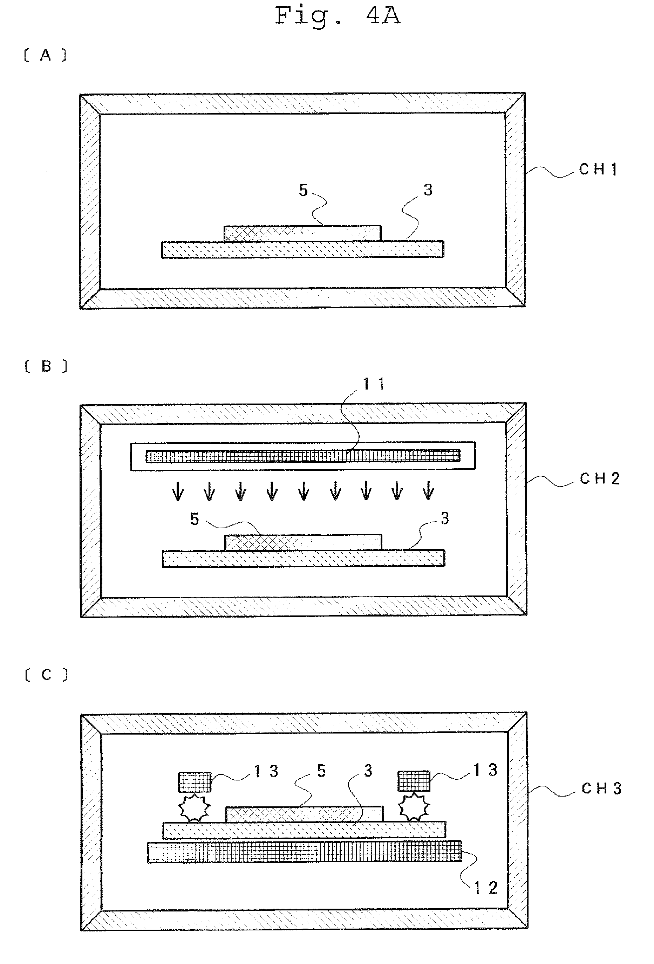

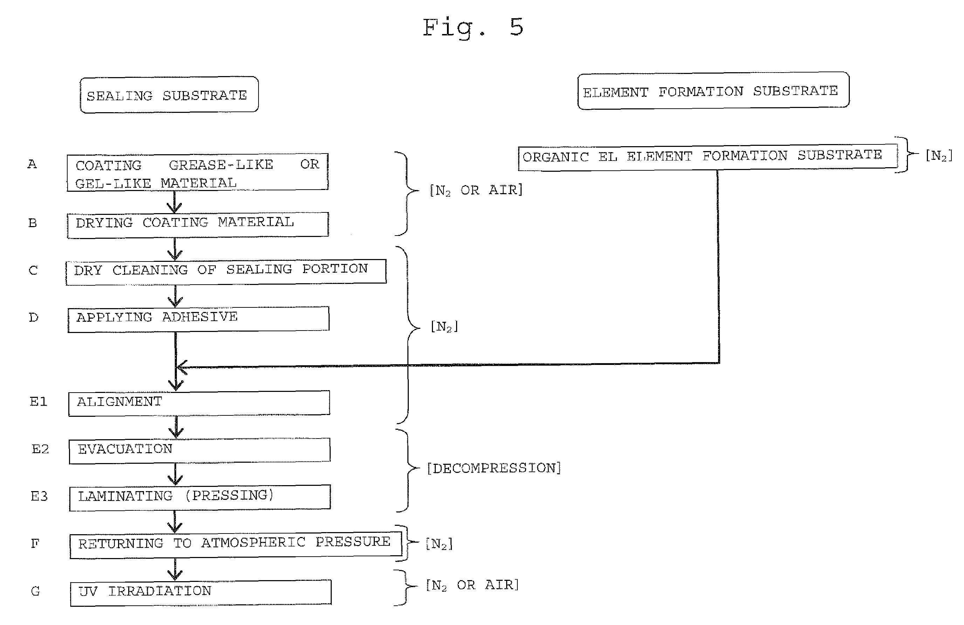

FIGS. 4A to 4C respectively explain a first example of the processing executed in each stage shown in FIG. 3. FIG. 5 is a flow chart of a first example of the manufacturing method for obtaining the organic EL light-emitting panel by using the manufacturing device.

FIGS. 4A to 4C explain the correspondence relationships with the chambers shown in FIG. 3 by using the same reference numerals CH1 to CH5 for identifying each chamber. The processes (A) to (G) of FIGS. 4A to 4C correspond to each process shown in FIG. 5.

As shown in FIG. 3, the sealing substrate 3 is fed from a sealing substrate feed stock to the chamber CH1 (a coating stage) provided with a coater. In the chamber CH1, as shown in the process (A) of FIG. 4A, a grease or a gel agent (assigned the same reference numeral as the grease layer 5 or the gel layer 5) is coated or attached onto one side of the plate-shaped sealing substrate 3. The grease 5 or the gel agent 5 contains the oligomer or the polymer having organosiloxane bond (-R₂SiO-) or fluorinated polyether (-CF₂CFYO-) as a skeleton. As shown in FIG. 5, the coating process is performed under a nitrogen gas atmosphere or an air atmosphere.

In the above case, the grease 5 or the gel agent 5 is coated to the central portion of the sealing substrate 3 by, for example, dispense or screen printing. The grease 5 or the gel agent 5 is a semi-solid material retaining its coated shape on the sealing substrate 3 and preferably has a viscosity of 3 Pa·s (pascal second) or more at normal temperature. There may be used a grease or a gel agent which is heated and fusion bonded after coated and increases in viscosity much more.

In the process of coating the grease 5 or the gel agent 5, in addition to the coating of the material, the gel agent 5 formed into a sheet may be attached (placed) on one side of the sealing substrate 3.

The sealing substrate 3 after the coating process is fed to the chamber CH2 (a heating and drying stage) by the feeding robot to be subjected to the process of heating and drying the grease 5 or the gel agent 5. As shown in the process (B) of FIG- 4A, the grease 5 or the gel agent 5 is heated by a heater 11, and is then preferably dried for 10 minutes at 100°C to 250°C. As shown in FIG. 5, the drying processing is performed under a nitrogen gas atmosphere.

In the heating and drying processing, when the grease 5 or the gel agent 5 contains, for example, synthetic zeolite, the grease 5 or the gel agent 5 is heated and dried at a low dew point, whereby the synthetic zeolite can exhibit a satisfactory moisture absorbent performance immediately before sealing. In this case, the heating temperature is preferably set to 100°C or more in order to promote the drying effect. Further, in order to avoid the deformation of the gel agent 5, the heating temperature is preferably set to 250°C or less.

The sealing substrate 3 after the heating and drying processing applied to the grease 5 or the gel agent 5 is fed to the chamber CH3 (cleaning and sealing-agent-application stage) by the feeding robot. In the chamber CH3, as shown in the process (C) of FIG. 4A, a sealing portion of the sealing substrate 3 to which the sealing agent is applied is dry-cleaned. As shown in FIG. 5, the dry cleaning process is performed under a nitrogen gas atmosphere.

As a method of the dry cleaning, normal-pressure plasma cleaning can be preferably used. The process (C) of FIG. 4A schematically shows the plasma cleaning. A lower electrode 12 is disposed along the lower surface of the sealing substrate 3, and upper electrodes 13 are disposed along the vicinity of the peripheral edge portion on the upper surface of the sealing substrate 3, that is, the sealing portion to which the sealing agent is applied. Organic contaminants are cleaned by the activation energy of plasma formed by discharge.

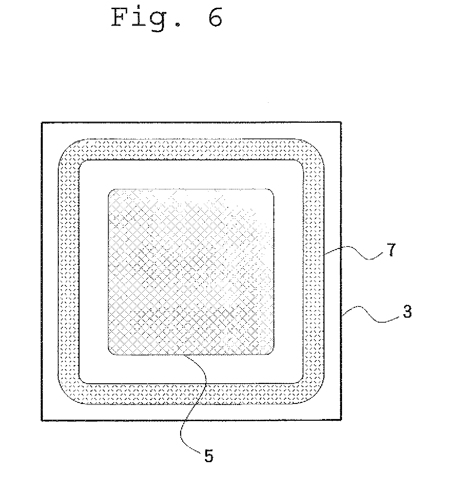

FIG. 6 is a top view of the sealing substrate 3 formed into a rectangular shape and schematically shows a position subjected to the dry cleaning. The gel agent 5 is coated onto the central portion of the upper surface of the seal ing substrate 3. The vicinity of the peripheral edge portion of the upper surface of the sealing substrate 3, that is, a sealing portion 7 to which a sealing agent is applied undergoes the cleaning action by the normal-pressure plasma cleaning. In the process to be described later, the sealing agent (adhesive) is applied to the sealing portion 7.

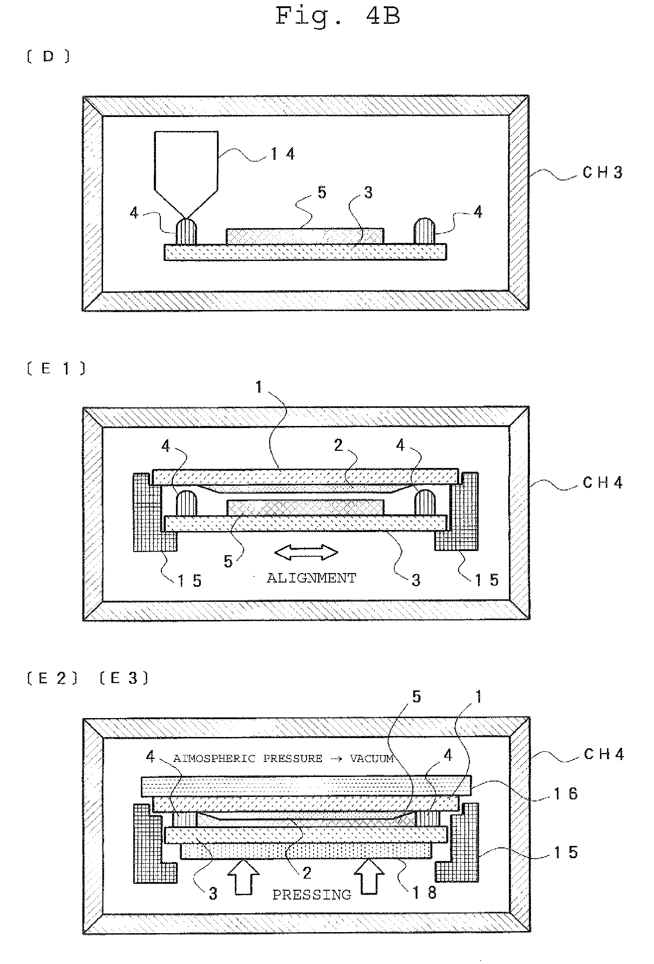

In the chamber CH3 shown in FIG. 3, the seal ing agent (adhesive) 4 is applied subsequent to the dry cleaning. As shown in the process (D) of FIG. 4B, the sealing agent 4 from an application nozzle 14 is applied along the sealing portion of the sealing substrate 3 subjected to the dry cleaning. As the adhesive 4, a UV curable resin can be preferably used. As shown in FIG. 5, the adhesive application process is performed under a nitrogen gas atmosphere.

The sealing substrate 3 onto which the adhesive 4 is applied in the above process is fed to the chamber CH4 (a lamination stage) by the feeding robot, as shown in FIG. 3. Meanwhile, the element formation substrate 1 on which the organic EL element 2 is film-formed by another deposition process (not shown) is transferred to the lamination stage. As shown in a process (E1) of FIG. 4B, the surface of the element formation substrate 1, on which the organic EL element 2 is formed, faces the surface of the sealing substrate 3, to which the grease 5 or the gel agent 5 is coated, and the element formation substrate 1 and the sealing substrate 3 are aligned with each other (alignment process).

The alignment process is executed in such a state that the element formation substrate 1 and the sealing substrate 3 are set in a schematically illustrated laminating device 15. As shown in FIG. 5, the alignment process is executed under a nitrogen gas atmosphere.

Subsequently, as shown in a process (E2) of FIG. 4B, a gas in the chamber CH4 is discharged, whereby the sealing substrate 3 and the element formation substrate 1, which are placed in the laminating device 15 so as to face each other, are placed in a decompression (vacuum) state.

As shown in a process (E3) of FIG. 4B, a lamination process is executed in a way that the auxiliary plate 18 is pressed upward under low pressure condition whereby the sealing substrate 3 and the element formation substrate 1 are approached to each other, and the surface coated with the grease 5 or the gel agent 5 is contacted with the side of the organic EL element 2 and adhered on to the organic EL element 2.

In the above embodiment, the auxiliary plate 18 is disposed under the sealing substrate 3 and the auxiliary plate 16 is disposed on a upper surface of the organic EL element 2 whereby a satisfactory adhesion is provided by pressing. As UV irradiation is not performed in this process, a metal plate or common glass can be used for the auxiliary plate 16 and 18 and there is no need to use expensive quartz glass.

In the lamination process, the sealing substrate 3 is pressed upward through the auxiliary plate 18 disposed on the lower surface of the sealing substrate 3. According to this constitution, the adhesive 4 applied along the outer peripheral edge of the sealing substrate 3 is in contact with the side of the element formation substrate 1 opposed to the sealing substrate 3. The surface coated with the grease 5 or the gel agent 5 is adhered onto the side of the organic EL element 2, and, at the same time, the grease 5 or the gel agent 5 is pressed and spread into the entire area of the space surrounded by the adhesive 4.

Namely, as shown in the process (A) of FIG. 4A showing the initial state, the grease or the gel agent is coated, in a suitable area, onto a substantially central portion of one side of the sealing substrate 3, whereby the grease layer 5 or the gel layer 5 is formed so as to be larger than the outer peripheral portion of the organic EL element 2 facing the grease layer or the gel layer.

In the decompression state in the lamination process, the pressure is set in a range of 1 Pa to 50000 Pa. Namely, when the pressure is less than 1 Pa, the substrates 1 and 3 are strongly pressure bonded by atmospheric pressure, and therefore, damage is applied to the organic EL element, whereby the rate of occurrence of defectives, such as a dark spot and a short, is increased. When the pressure is more than 50000 Pa, the adhesion between the grease 5 or the gel agent 5 and the organic EL element 2 is deteriorated, and there occurs such a problem of deterioration of the adhesion of the sealing agent (adhesive) 4.

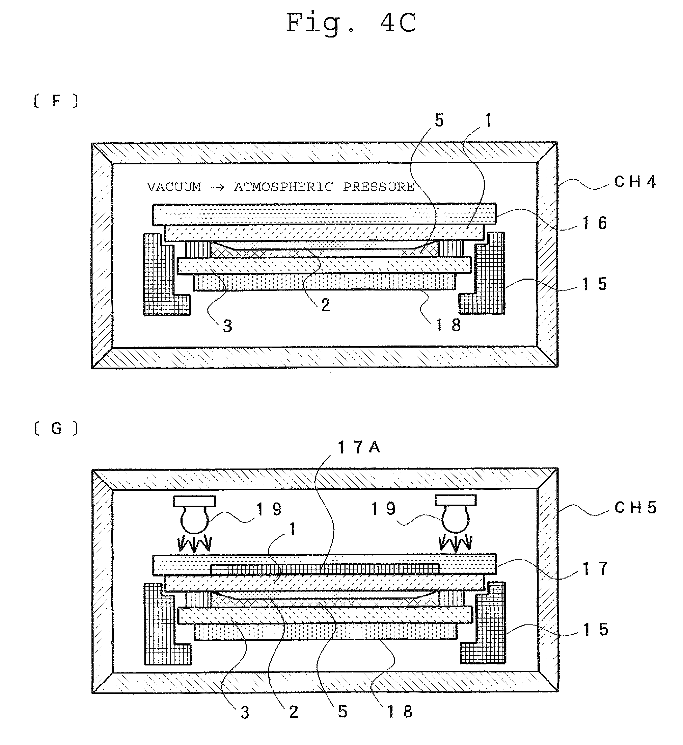

Subsequently, as shown in a process (F) of FIG. 4C, the pressure in the chamber CH4 is returned to atmospheric pressure, while maintaining the positional relationship in the laminated state of the substrates 1 and 3 ; however, the positional relationship obtained by alignment of the substrates, the adhesiveness between the grease or the gel agent and the organic EL element, and the adhesiveness of the adhesive are maintained by the difference between the sealed decompression space, provided between the substrates 1 and 3, and atmospheric pressure.

Namely, the chamber CH4 has a pressure regulating function of decompressing the inside of the chamber CH4 and returning the decompression state in the chamber CH4 to atmospheric pressure. The chamber CH4 is operated so that even if the lamination pressure in the lamination stage is released, by virtue of the pressure difference between the sealed decompression space, provided between the sealing substrate 3 and the element formation substrate 1, when the inside of the chamber CH4 is in the decompression state and the sealed decompression space when the decompression state in the chamber CH4 is returned to the atmospheric pressure, the adhesion and the positional relationship between the substrates 1 and 3 are maintained.

Thereafter, a process of hardening the adhesive 4 to form the sealing portion is executed. In FIG. 3, the process is executed in the chamber CH5 (a hardening stage of the adhesive) - A process (G) of FIG. 4C shows an example of hardening the adhesive to execute the sealing processing.

In this process, a UV projection lamp 19 is disposed above a UV transmitting glass 17, and the UV light is projected on the adhesive 4 through the element formation substrate, whereby the adhesive 4 can be hardened. The UV transmitting glass 17 have the UV cut mask 17A which prevents the UV light from the UV projection lamp from being projected on the organic EL element 2 to thereby prevent the organic EL element 2 from being damaged.

In the above example, as the positional relationship of the substrates 1 and 3 , the adhesiveness between the grease or the gel agent and the organic EL element, and the adhesiveness of the adhesive are maintained by the difference between the sealed decompression space, provided between the substrates 1 and 3, and atmospheric pressure, the UV transmitting glass which has the UV cut mask 17A is not required to be pressed by a large force in the UV projection process. Therefore as the UV transmitting glass 17 is not necessary to be an expensive thick quartz glass, a low-cost thin plate soda glass having the UV cut mask or a soda glass having a metal plate with a UV cut mask function can be used as the UV transmitting glass 17.

Meanwhile, a frit agent as typified by glass paste is used instead of the adhesive 4, and it is heated and hardened by laser radiation, whereby thermal fusion bonding means for forming the sealing portion can be used. Thereafter, the auxiliary plates 16 and 18 are removed, and the pressure is returned to atmospheric pressure. The molded product is then demolded from the laminating device, whereby the organic EL light-emitting panel can be obtained. As shown in FIG. 3, the obtained organic EL light-emitting panel is fed in a substrate stock chamber.

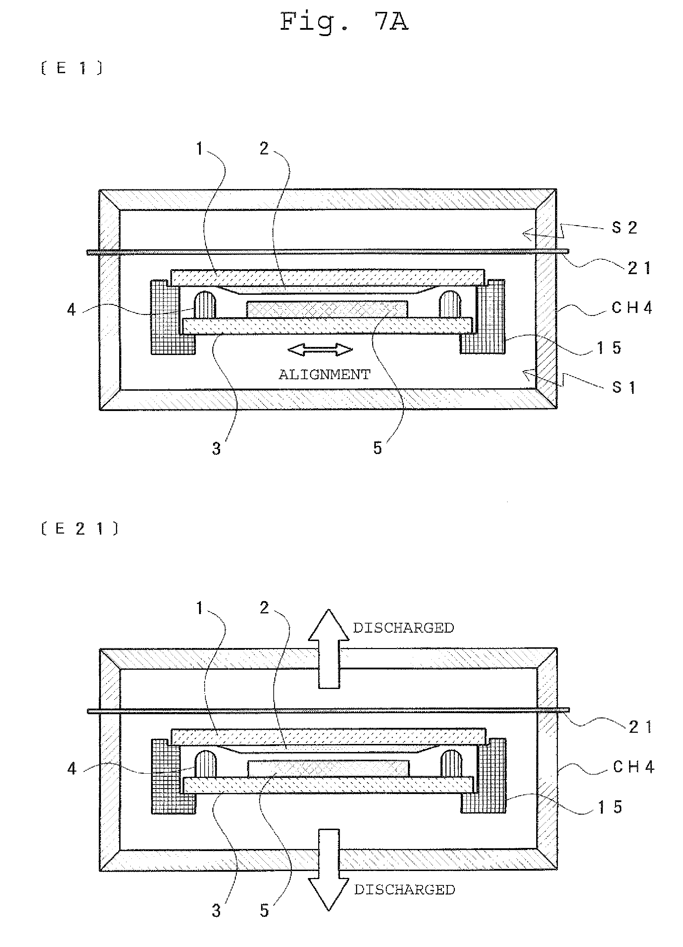

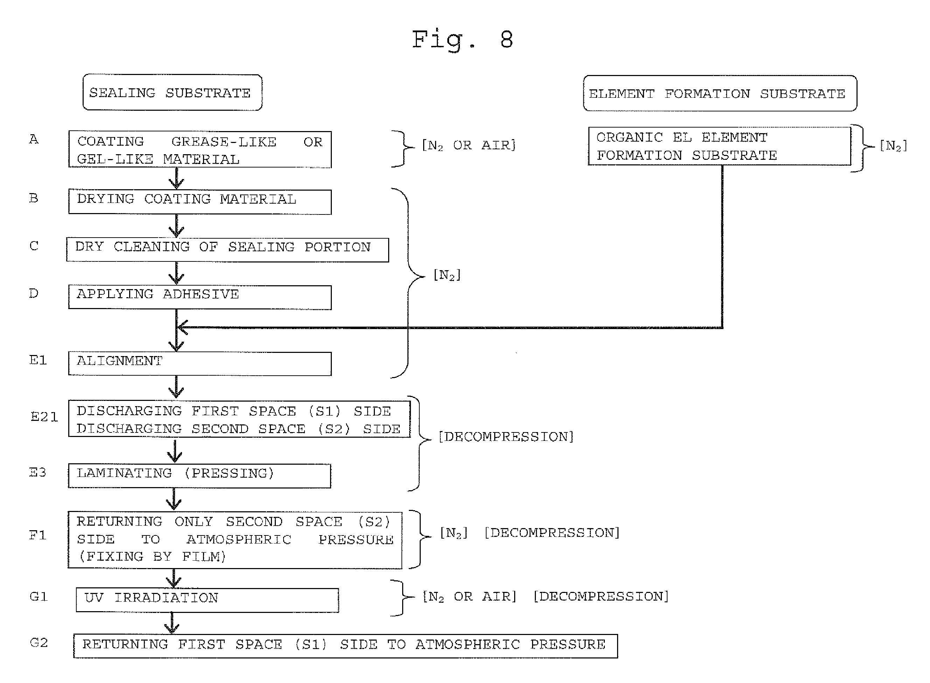

FIGS. 7A to 7C explain a second example of a processing executed in each stage in the manufacturing device schematically shown in FIG. 3. FIG. 8 is a flow chart of the second example of the manufacturing method for obtaining the organic EL light-emitting panel by using the manufacturing device. FIGS. 7A to 7C explain the correspondence relationships with the chambers shown in FIG. 3 by using the same reference numerals CH1 to CH5 for identifying each chamber. The processes (E1) to (G2) of FIGS. 7A to 7C correspond to each process shown in FIG. 8.

Incidentally, the second manufacturing process shown in FIGS. 7A to 7C, to be hereinafter described, follows the manufacturing process of (A) to (D) of FIGS. 4A and 4B (the sealing agent (adhesive) application process). Thus, in FIGS. 7A to 7C, the components corresponding to those described in FIGS. 4A and 4B are assigned the same reference numerals and the detailed description thereof will be omitted.

In the second manufacturing process shown in FIGS. 7A to 7C, a film-like sheet 21 partitioning the inside of the chamber is used. The film-like sheet 21 is formed of, for example, PET and used in the lamination process of the substrates. The sheet 21 partitions the inside of the chamber into a first space S1 in which the constituents of the organic EL light-emitting panel including the element formation substrate and the sealing substrate 3 are accommodated and a second space S2 without them.

The sheet 21 is deformed by the pressure difference between the first space S1 and the second space S2 and operates to fix and position the organic EL light-emitting panel. The reference numerals S1 and S2 representing the first and second spaces are used only in the process (E1) of FIG. "7A.

In the process (E1) of FIG. 7A, the alignment process for aligning the element formation substrate 1 and the sealing substrate 3 is executed so that the surface of the element formation substrate 1 on which the organic EL element 2 is formed faces the surface of the sealing substrate 3 onto which the grease 5 or the gel agent 5 is coated.

The element formation substrate 1 and the sealing substrate 3 are aligned in such a state of being set in the schematically shown laminating device 15. As shown in FIG. 8, the alignment process is executed under a nitrogen gas atmosphere.

Subsequently, as shown in a process (E21) of FIG. 7A, a gas on the side of the second space S2 of the chamber CH4 and a gas on the side of the first space S1 of the chamber CH4 are discharged, and each space is placed in a decompression state. Each gas may be started to be discharged with a time difference between the first space S1 and the second space S2.

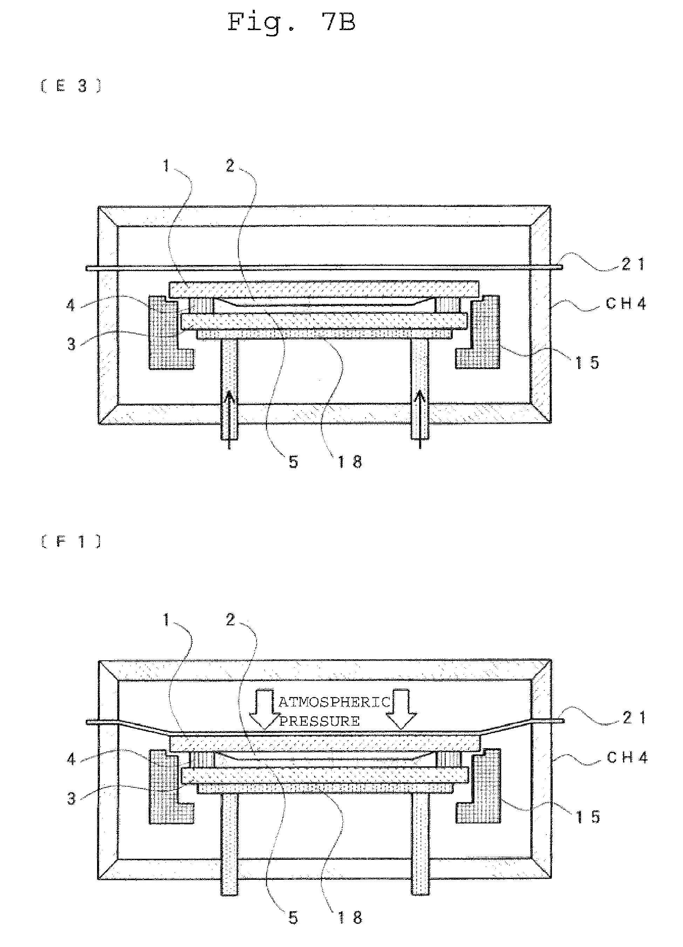

Then, there is executed the lamination process in which in the decompression state of the first and second spaces S1 and S2, the sealing substrate 3 and the element formation substrate 1 make approach to each other, and the surface coated with the grease 5 or the gel agent 5 is adhered to the side of the organic EL element 2. Namely, as shown inaprocess (E3) of FIG. 7B, the sealing substrate 3 is brought into contact with the element formation substrate 1.

In the above case, as shown in the process (E3) of FIG. 7B, the auxiliary plate 18 formed of a metal plate is provided on the lower surface of the sealing substrate 3 for pressing purposes.

In the lamination process, the sealing substrate 3 is pressed upward through the auxiliary plate 18 disposed on the lower surface of the sealing substrate 3. According to this constitution, the adhesive 4 applied along the outer peripheral edge of the sealing substrate 3 is in contact with the side of the element formation substrate 1 opposed to the sealing substrate 3. The surface coated with the grease 5 or the gel agent 5 is brought into contact with the side of the organic EL element 2 to be adhered thereto, and, at the same time, the grease 5 or the gel agent 5 is pressed and spread into the entire area of the space surrounded by the adhesive 4.

In the decompression state of the first space S1 in the lamination process, the pressure is set in a range of 1 Pa to 50000 Pa. The preferred range of the decompression set at this time has been described in the description of the process (E3) of FIG. 4B.

Subsequently, as shown in a process (F1) of FIG. 7B, the second space S2 is returned to atmospheric pressure, while maintaining the positional relationship in the laminated state of the substrates 1 and 3. The second space S2 is returned to atmospheric pressure and thereby the element formation substrate 1 is adhered by the deformation of the sheets 21, and the element formation substrate 1 and the sealing substrate 3 constituting the organic EL light-emitting panel are fixed and positioned by the sheet 21.

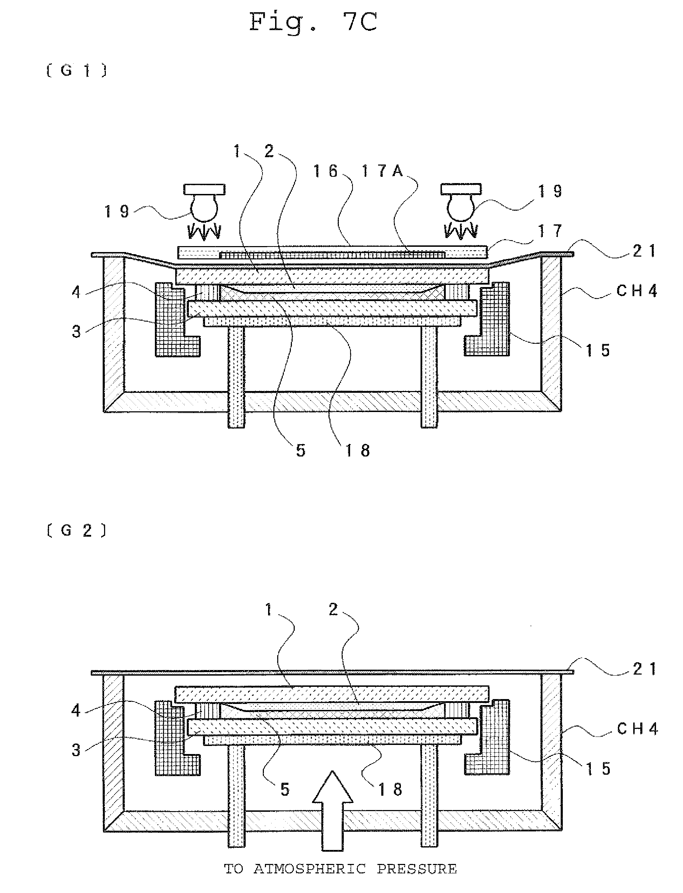

As shown in a process (G1) of FIG. 7C, in the above state, the adhesive 4 is hardened to form the sealingportion. In the process, the upper portion of the chamber CH4 forming the first space S1 is removed, and the UV transmitting glass 17 with the UV cut mask 17A is placed. The UV projection lamp 19 is disposed above the UV transmitting glass 17. The UV light is projected on the adhesive 4 through the UV transmitting glass 17, the sheet 21, and the element formation substrate 1, whereby the adhesive 4 can be hardened. The UV transmitting glass 17 with the UV cut mask 17A is disposed on the sheet 21 in this embodiment, but the UV transmitting glass 17 can be disposed between the sheet 21 and the element formation substrate 1.

Thereafter, as shown in a process (G2) of FIGS. 7C and 8, the first space S1 is returned to atmospheric pressure, the UV transmitting glass 17 with the UV cut mask 17A is removed, and the molded product is demolded from the laminating device, whereby the organic EL light-emitting panel can be obtained.

According to the second manufacturing device and method shown in FIGS. 7A to 7C and FIG. 8, the sheet 21 partitioning the inside of the chamber into the first space S1 and the second space S2 is used, and the sheet 21 is deformed by the pressure difference between the first space S1 and the second space S2 to operate so as to fix and position the organic EL light-emitting panel, whereby even if the second space S2 is returned to atmospheric pressure, the UV irradiation can be performed while the position of the organic EL light-emitting panel is precisely maintained between the sheet 21 and the auxiliary plate 18 on the lower side. Therefore, this invention can provide the device and method which require no conventional expensive member which has both a UV permeability and a high rigidity, such as quartz glass because a low-cost thin plate soda glass having the UV cut mask or a soda glass having a metal plate with a UV cut mask function can be used as the UV transmitting glass 17.

In the second manufacturing device and method, although a grease-like or gel-like material is used as a sealing material, the manufacturing device and method can be used also when a well-known sealing material such as an inert gas, an inert liquid, or a resin is used.

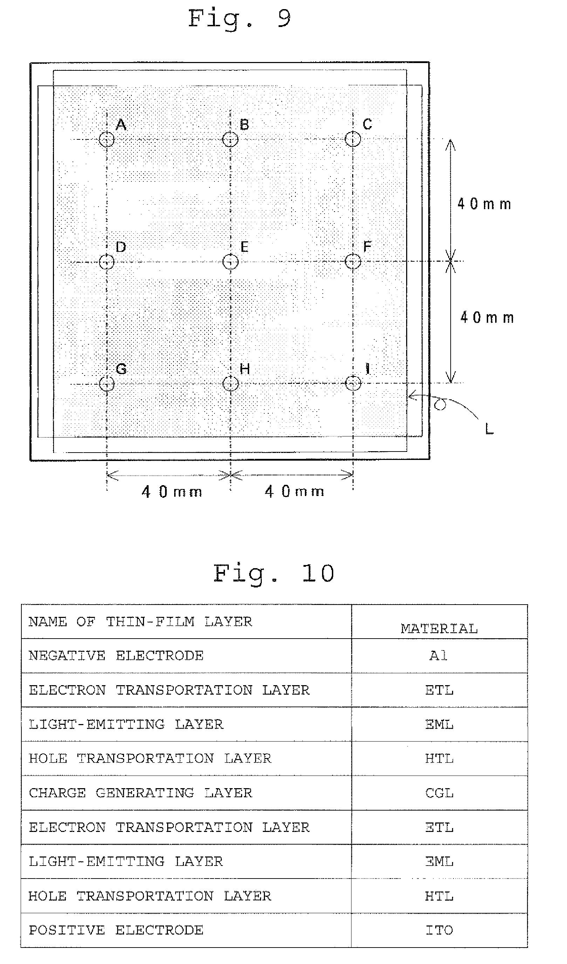

For the organic EL light-emitting panel obtained by the above manufacturing process, a result of the measurement of the surface temperature when the organic EL light-emitting panel is driven to emit light is shown in FIGS- 9 to 13. FIG. 9 shows an embodiment of a prototype produced for measurement. In this example, for the organic EL light-emitting panel with a light-emitting part L formed into a square with one side of 115 mm, each temperature of nine points A to I of the front side (the element formation substrate 1 side) of the organic EL light-emitting panel is measured.

FIG. 10 shows an example of a laminated structure of the prototype of the organic EL element 2. The names of layers and the functional materials constituting these layers are shown in FIG. 10. In the example shown in FIG. 10, the organic EL element 2 has a multiphoton structure with two light-emitting layers.

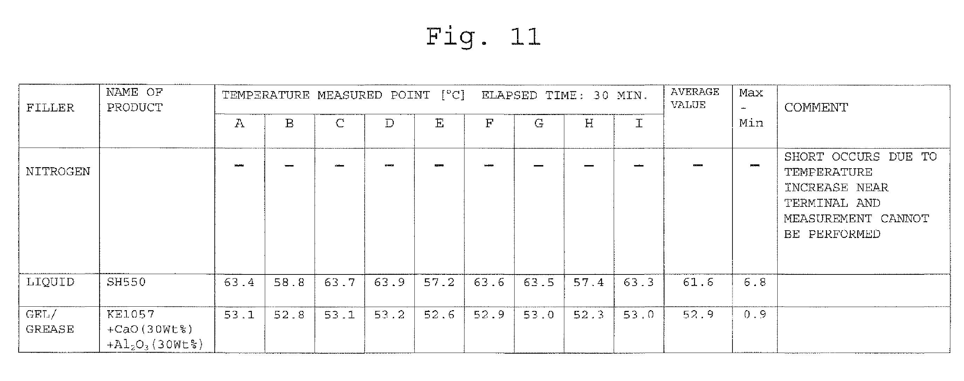

FIG. 11 shows a measured temperature (°C) at the points A to I, shown in FIG. 9, for a comparison in which nitrogen is filled in the space between the element formation substrate 1 and the sealing substrate 3, a comparison in which a liquid is filled therein, and the case according to this invention in which a gel or a grease is filled therein. The measured values are the temperature at a time point after a lapse of 3 minute from the application of current. In any prototype for the measurement, an aluminum soaking plate with a plate thickness of 0.5 mm, to which a heat dissipating agent such as alumina is applied, is attached to the outside of the sealing substrate 3 side through a heat-transfer member. As the soaking plate, other metals such as a copper plate can be used.

As the liquid as the filler shown in the comparative example, a methylphenyl silicone oil (SH550) from Dow Corning Toray Co., Ltd. reduced in pressure and heated at 100°C is used. In the organic EL light-emitting panel according to the method of this invention, for example, KE1057 from Shin-Etsu Chemical Co., Ltd. of 50 wt% as a silicone gel, calcium oxide of 30 wt% as a moisture absorbent, aluminum oxide of 20 wt% as a heat-transfer material are used in the gel layer.

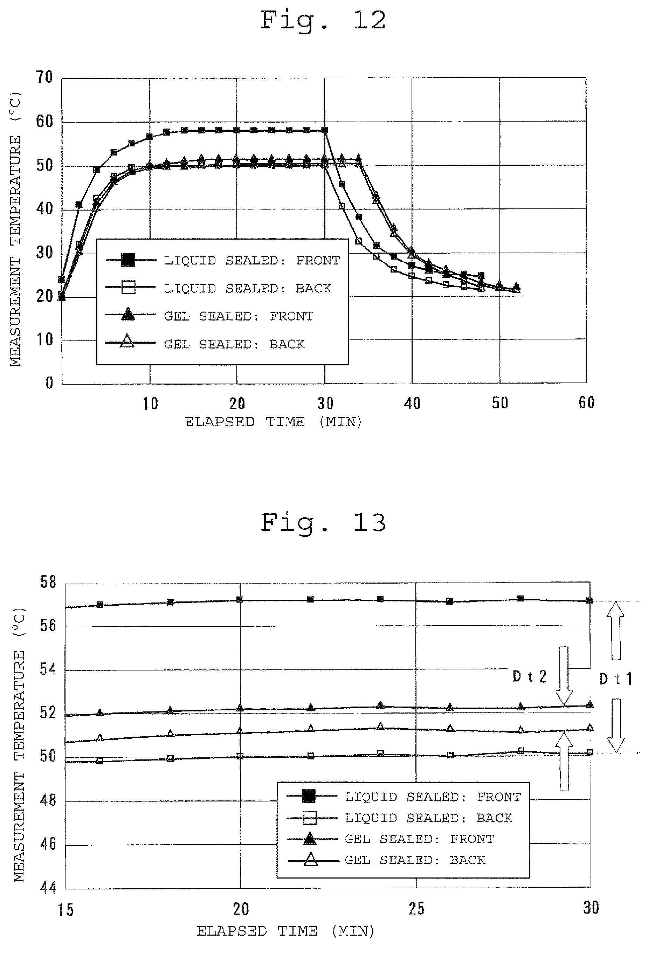

FIG. 12 shows, in the comparative example in which the liquid is the filler and the organic EL light-emitting panel obtained by the manufacturing method of this invention, in which the gel is the filler, the temperature (°C) of the front and back sides of the panel at the point E shown in FIG. 9 from the application of current to a lapse of 30 minutes and the subsequent elapse of time after the power off. FIG. 13 is an enlarged scale of FIG. 12 and shows the measurement result from the application of current to a lapse of 15 to 30 minutes.

In FIGS. 12 and 13, the measurement result in the organic EL light-emitting panel according to the manufacturing method of this invention is expressed as "gel sealed: front (a light extraction side)" and "gel sealed: back (sealing side)". Meanwhile, the compared measurement result in the prior art example is expressed as "liquid sealed: front (a light extraction side)" and "liquid sealed: back (sealing side)".

As shown in FIG. 11, according to the organic EL light-emitting panel using the gel as the filler, according to the manufacturing method of this invention, it can be understood that the average value of the temperatures at points A to I is significantly reduced compared with the light-emit ting panel using the liquidas the filler. Further, it can be understood that the difference between the maximum value and the minimum value of the points A to I (Max - Min) is extremely small.

As shown in FIG. 13, according to the measurement result in the light-emitting panel using the liquid as the filler, the temperature difference between the front and back sides at the time point after a lapse of 30 minutes from the application of current is about 7.0°C, as represented as Dt1. Meanwhile, the temperature difference between the front and back sides of the organic EL light-emitting panel, according to the manufacturing method of this invention, can be suppressed to about 1.3°C at the same time point, as represented as Dt2.

Thus, according to the organic EL light-emitting panel according to the manufacturing method of this invention, it can be understood, also based on the measurement result, the operational effect described in the effect of the invention can be exercised. Further, an organic EL light-emitting panel using a large substrate can be manufactured by a low-cost manufacturing device.

## Claims

1. A method for manufacturing an organic EL light-emitting panel, in which an organic EL element formed on an element formation substrate is sealed so as to provide a sealed space between the element formation substrate and a sealing substrate facing the element formation substrate, and a grease-like or gel-like material is filled in the sealed space between the element formation substrate and the sealing substrate, comprising:
a coating or attaching step of coating or attaching the grease-like or gel-like material onto a surface of the sealing substrate; and
a laminating step of sealing the peripheral edge portion between the sealing substrate and the element formation substrate by a sealing agent in such a state that the surface of the sealing substrate onto which the grease-like or gel-like material is coated or attached and the surface of the element formation substrate on which the organic EL element is formed are opposed to each other.

2. The method for manufacturing an organic EL light-emitting panel as claimed in claim 1, further comprising after the coating or attaching step, a drying step of drying the grease-like or gel-like material coated onto the sealing substrate, wherein the laminating step is executed after the drying step.

3. The method for manufacturing an organic EL light-emitting panel as claimed in claim 2, wherein the drying step is executed in a range of temperature of 100°C to 250°C.

4. The method for manufacturing an organic EL light-emitting panel as claimed in any one of claims 1 to 3, further comprising after the coating or attaching step or the drying step, a sealing substrate cleaning step of dry cleaning a sealing portion of the sealing substrate to which the sealing agent is applied and a sealing agent applying or attaching step of applying or attaching the sealing agent to the sealing portion of the sealing substrate after the cleaning step, wherein the laminating step is executed using the sealing agent applied or attached in the sealing agent applying or attaching step.

5. The method for manufacturing an organic EL light-emitting panel as claimed in claim 4, wherein normal-pressure plasma cleaning is used in the dry cleaning.

6. The method for manufacturing an organic EL light-emitting panel as claimed in any one of claims 2 to 5, further comprising, before the laminating step, a decompression step of discharging a gas in a chamber in which the sealing substrate and the element formation substrate are accommodated, wherein under decompression, there is executed the laminating step of adhering the surface of the sealing substrate, onto which a grease or a gel agent is coated or attached, to the surface of the element formation substrate on which the organic EL element is formed.

7. The method for manufacturing an organic EL light-emitting panel as claimed in claim 6, wherein the decompression state in the laminating step is 1 Pa to 50000 Pa, and further comprising a sealing agent hardening step of hardening the sealing agent while maintaining the pressure in a sealed space after the pressure is returned to atmospheric pressure.

8. The method for manufacturing an organic EL light-emitting panel as claimed in claim 7, wherein a UV curable resin is used as the sealing agent, and the UV curable resin is hardened by using UV light while maintaining the laminating state, attributable to a pressure difference between atmospheric pressure and a pressure in the sealed space, in the laminating step.

9. The method for manufacturing an organic EL light-emitting panel as claimed in claim 7, wherein an inorganic frit agent is used as the sealing agent, and the glass paste is heated and fusion bonded by laser irradiation while maintaining the laminating state in the laminating step.

10. The method for manufacturing an organic EL light-emitting panel as claimed in any one of claims 1 to 9, wherein the grease-like or gel-like material contains synthetic zeolite as a moisture absorbent, and when a sealing substrate formed into a plate shape is used, the synthetic zeolite is contained in the grease-like or gel-like material in a weight ratio of 10 to 80%, and the thickness of a grease layer or a gel layer containing the moisture absorbent is set to a range of 10 to 100 µm.

11. The method for manufacturing an organic EL light-emitting panel as claimed in any one of claims 1 to 9, wherein the grease-like or gel-like material contains synthetic zeolite as a moisture absorbent, and when a sealing substrate with a recessed cross-sectional surface, in which a recess is provided in the central portion so that the peripheral edge portion is in contact with the element formation substrate side, is used, the synthetic zeolite is contained in the grease-like or gel-like material in a weight ratio of 10 to 80%, the amount of the grease-like or gel-like material containing a moisture absorbent is set so that the grease-like or gel-like material is filled in the recess of the sealing substrate to adhere to the organic EL element, and the thickness of a grease layer or a gel layer containing the moisture absorbent is set to a range of 10 to 500 µm.

12. The method for manufacturing an organic EL light-emitting panel as claimed in any one of claims 1 to 9, wherein in the laminating step of adhering the element formation substrate and the sealing substrate, at least one of the element formation substrate and the sealing substrate adheres to a film-like sheet disposed in a lamination stage, whereby the organic EL light-emitting panel is fixed and positioned.

13. The method for manufacturing an organic EL light-emitting panel as claimed in claim 12, wherein a sealing agent in a peripheral portion of the organic EL panel is hardened in such a state that a side where the film-like sheet for fixing and positioning the organic EL panel and the organic EL panel are in contact with each other is in a decompression state of 1 Pa to 50000 Pa, and a side where the film-like sheet and the organic EL panel are not in contact with each other is in an atmospheric pressure state.

14. A device for manufacturing an organic EL light-emitting panel, in which an organic EL element formed on an element formation substrate is sealed so as to provide a sealed space between the element formation substrate and a sealing substrate facing the element formation substrate, and a grease-like or gel-like material is filled in the sealed space between the element formation substrate and the sealing substrate, comprising:
a coating or attaching stage in which the grease-like or gel-like material is coated or attached onto a surface of the sealing substrate; and
a lamination stage inwhich the peripheral edge portion between the sealing substrate and the element formation substrate is sealed by a sealing agent in such a state that the surface of the sealing substrate onto which the grease-like or gel-like material is coated or attached and the surface of the element formation substrate on which the organic EL element is formed are opposed to each other.

15. The device for manufacturing an organic EL light-emitting panel as claimed in claim 14, further comprising a heating and drying stage in which the grease-like or gel-like material coatedor attached on the surface of the sealing substrate in the coating or attaching stage is heated and dried, and feeding means for feeding the sealing substrate to the lamination stage after the heating and drying processing in the heating and drying stage.

16. The device for manufacturing an organic EL light-emitting panel as claimed in claim 15, further comprising a cleaning and sealing-agent-application or attachment stage in which a sealing portion of the sealing substrate processed in the heating and drying stage is dry cleaned, and a sealing agent is applied or attached to the dry cleaned position, wherein the sealing substrate processed in the cleaning and sealing-agent-application or attachment stage is fed to the lamination state by the feeding means.

17. The device for manufacturing an organic EL light-emitting panel as claimed in claim 16, wherein dry cleaning means for dry cleaning the sealing portion of the sealing substrate uses normal-pressure plasma cleaning means.

18. The device for manufacturing an organic EL light-emitting panel as claimed in any one of claims 14 to 17, wherein the lamination stage comprises laminating means, which adheres the surface of the sealing substrate, onto which the grease or the gel agent is coated or attached, to the side of the organic EL element on the element formation substrate at a predetermined lamination pressure.

19. The device for manufacturing an organic EL light-emitting panel as claimed in any one of claims 14 to 17, wherein the lamination stage comprises laminating means, which adheres the surface of the sealing substrate, onto which the grease or the gel agent is coated or attached, to the organic EL element side on the element formation substrate at a predetermined lamination pressure under decompression.

20. The device for manufacturing an organic EL light- remitting panel as claimed in claim 19, wherein a chamber constituting the lamination stage has a pressure regulating function of decompressing the inside of the chamber and returning the decompression state to atmospheric pressure, and even when a lamination pressure in the lamination stage is released by a pressure difference between a sealed decompression space between the sealing substrate and the element formation substrate when the inside of the chamber is in the decompression state and the space when the decompression state in the chamber is returned to the atmospheric pressure, the adhesion and the positional relationship between the sealing substrate and the element formation substrate are maintained.

21. The device for manufacturing an organic EL light-emitting panel as claimed in claim 20, further comprising a sealing agent hardening stage in which the sealing agent is hardened in such a state that the adhesion and the positional relationship between the element formation substrate and the sealing substrate are maintained.

22. The device formanufacturingan organic EL light-emitting panel as claimed in any one of claims 14 to 21, wherein in the laminating means for adhering the element formation substrate and the sealing substrate in the lamination stage, at least one of the element formation substrate and the sealing substrate is adhered to the film-like sheet disposed in the lamination stage, whereby the organic EL light-emitting panel is fixed and positioned.

23. The device for manufacturing an organic EL light-emitting panel as claimed in claim 22, further comprising a sealing agent hardening stage in which a sealing agent in a peripheral portion of the organic EL panel is hardened in such a state that a side where the film-like sheet for fixing and positioning the organic EL panel and the organic EL panel are in contact with each other is in a decompression state of 1 Pa to 50000 Pa, and a side where the film-like sheet and the organic EL panel are not in contact with each other is in an atmospheric pressure state.

24. The device for manufacturing an organic EL light-emitting panel as claimed in claims 21 and 23, wherein the sealing agent hardening stage comprises UV irradiation means which hardens UV curable resin as a sealing agent.

25. The device for manufacturing an organic EL light-emitting panel as claimed in claims 21 and 23, wherein the sealing agent hardening stage comprises laser irradiation means which heats and fusion bonds an inorganic frit agent as a sealing agent.
